(19) **Europäisches Patentamt**
**European Patent Office**
**Office européen des brevets**

(11) **EP 1 339 025 B1**

(12) **EUROPÄISCHE PATENTSCHRIFT**

(45) Veröffentlichungstag und Bekanntmachung des Hinweises auf die Patenterteilung:
**03.01.2007 Patentblatt 2007/01**

(51) Int Cl.:
*G07C 9/00* (2006.01)     *E05B 65/20* (2006.01)
*H03K 17/945* (2006.01)

(21) Anmeldenummer: **03003730.3**

(22) Anmeldetag: **19.02.2003**

(54) **Kraftfahrzeug mit Auslösesignalgeber**

Vehicle with release trigger

Véhicule avec générateur d'un signal de déclenchement

(84) Benannte Vertragsstaaten:
**AT BE BG CH CY CZ DE DK EE ES FI FR GB GR HU IE IT LI LU MC NL PT SE SI SK TR**

(30) Priorität: **20.02.2002 DE 10207167**
**10.04.2002 DE 10215591**

(43) Veröffentlichungstag der Anmeldung:
**27.08.2003 Patentblatt 2003/35**

(73) Patentinhaber: **Kiekert Aktiengesellschaft**
**42579 Heiligenhaus (DE)**

(72) Erfinder:
• **van Gastel, Peter**
**40699 Erkrath (DE)**
• **Lindic, Ico**
**45309 Essen (DE)**

(56) Entgegenhaltungen:
**DE-A- 19 620 059**        **DE-A- 19 701 899**
**US-A- 5 730 165**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft ein Kraftfahrzeug mit einem Auslösesignalgeber Kraftfahrzeug, beispielsweise zur Einleitung eines Frage-/Antwort-Dialogs im Rahmen einer Zugangsberechtigungsprüfung, mit einem kapazitiv arbeitenden Sensor, und mit einer Auswerteeinheit, wobei der Sensor Annäherungen und/oder Berührungen beispielsweise einer Person als zugehörige Kapazitätsänderungen erfasst und an die Auswerteeinheit weiterleitet.

Ein Auslösesignalgeber der eingangs beschriebenen Gestaltung wird im Rahmen der EP 0 954 098 A2 beschrieben. Bei dem bekannten Erkennungssystem ist ein Detektor als Auswerteeinheit zur Erfassung von Änderungen in der Kapazität eines Kondensators mit variabler und von der Nähe einer Person abhängiger Speicherfähigkeit vorgesehen. Mit Hilfe des Detektors werden Veränderungen dieses Kondensators erfasst, wobei sich der Kondensator aus einer kapazitiven Platte und beispielsweise einer Hand des zugehörigen Benutzers zusammensetzt, welche zusammengenommen einen Kondensator bilden, wenn sich die Hand der vorgenannten Platte nähert. Um nun die damit verbundenen Kapazitätsveränderungen feststellen zu können, ist die kapazitive Platte mit dem betreffenden Detektor verbunden, welcher eine Oszillatorschaltung aufweist, die ihrerseits mit einem Phasenvergleicher eines Phasenregelkreises verbunden ist.

Das Ausgangssignal aus dem Phasenregelkreis wird in einem Komparator ausgewertet. Eine Kapazitätsänderung des Kondensators aus der kapazitiven Platte und der Hand bewirkt eine Änderung in der Frequenz des Oszillators, welcher ansonsten bei einer konstanten Frequenz arbeiten würde. Beispielsweise erhöht sich durch die Annäherung der Hand die Kapazität, was ein Absinken der Oszillator-Frequenz zur Folge hat.

Diese Frequenzwandlung bewirkt eine Phasenänderung in dem Ausgangssignal des Oszillators, welches durch den Phasenvergleicher des Phasenregelkreises geleitet wird, um ein Störsignal oder Feedback-Signal des Phasenregelkreises zu erzeugen. Das Störsignal wird in den Komparator zum Vergleich mit einem vorgegebenen unteren Grenzpegel eingegeben. Wenn sich also die Hand dem Kondensator nähert, wird ein Störsignal von dem Phasenregelkreis aus erzeugt und - falls dieses Signal den unteren Grenzpegel überschreitet - wird der Komparator ein entsprechendes Ausgangssignal abgeben.

Die beschriebene Vorgehensweise ist relativ aufwendig und letztlich an die zuverlässige Funktion des Oszillators gebunden.

Daneben kennt man natürlich auch Auslösesignalgeber, welche einen Frage-/Antwort-Dialog im Rahmen einer Zugangsberechtigungsprüfung bei einem Kraftfahrzeug per manueller Schalterbetätigung auslösen (vgl. EP 0 218 251 B1).

Aus der US-A 5,730,165 ist eine Vorrichtung und ein Verfahren zum Messen der Kapazität einer Platte gegen Erde bekannt. Für eine Anwendung in einem Kraftfahrzeug ist diese Lösung nicht geeignet.

Der Erfindung liegt das technische Problem zugrunde, einen Auslösesignalgeber der eingangs beschriebenen Gestaltung so weiter zu entwickeln, dass bei einfachem und kostengünstigem Aufbau eine zuverlässige Annäherungssensierung gegeben ist.

Zur Lösung dieser technischen Problemstellung schlägt die Erfindung bei einem gattungsgemäßen Auslösesignalgeber vor, dass die Kapazitätsänderungen als Variationen der Aufladezeit und/oder Entladezeit des Sensors ermittelt werden. - Üblicherweise verfügt der Sensor über eine Leitfähigkeitselektrode, die auf Annäherungen/Berührungen der Person im Sinne einer Kapazitätsänderung des aus der Leitfähigkeitselektrode und der Person gebildeten Kondensators reagiert. Zumeist hat eine entsprechende Annäherung oder Berührung beispielsweise einer Hand der Person zur Folge, dass sich die Kapazität des aus der Leitfähigkeitselektrode und der Hand gebildeten Kondensators erhöht.

Dieser Umstand lässt sich im Kern darauf zurückführen, dass die Kapazität C des Kondensators reziproportional vom Plattenabstand d abhängt, das heißt es gilt:

$$(1) \quad C \propto \frac{1}{d} \quad .$$

Folglich steigt die Kapazität bei geringer werdendem Plattenabstand d an.

Der Sensor weist bevorzugt wenigstens einen Referenzkondensator auf, welcher turnusmäßig aufgeladen wird, wobei die Aufladezeit mit Hilfe der Auswerteeinheit bestimmt wird und als Referenzzeitspanne für die Auswertung von Annäherungen oder Berührungen der Person zur Verfügung steht. Darüber hinaus lässt sich der Referenzkondensator turnusmäßig entladen. Daneben kann ein Parallelkondensator (zusätzlich zum aus der Leitfähigkeitselektrode und der Hand der Person ausgebildeten Kondensator) vorgesehen werden. Auch dieser Parallelkondensator wird turnusmäßig geladen und entladen. Der Parallelkondensator gibt seine Ladung beim Entladen an den Referenzkondensator ab, wobei der Referenzkondensator während des Ladevorganges des Parallelkondensators von einer zugehörigen Spannungsquelle abgekoppelt ist.

Die Erfindung wertet also im Kern Änderungen der Aufladezeit des Referenzkondensators aus, die durch Annäherungen der Hand an die Leitfähigkeitselektrode modifiziert werden. Dabei wird von der Erkenntnis ausgegangen, dass im Regelfall bei den beschriebenen Ladevorgängen einzig der Referenzkondensator zunehmend aufgeladen wird, weil insofern der parallel hierzu angeordnete Kondensator aus Leitfähigkeitselektrode und Hand mit einer Kapazität nahezu 0 ausgerüstet ist. Das lässt sich auf den großen Abstand der Hand von der Leitfähigkeitselektrode und die Beziehung (1) zurückführen.

Nähert sich jedoch die Hand der Leitfähigkeitselektrode, so erhöht sich die Kapazität des Kondensators aus Leitfähigkeitselektrode und Hand. Das hat zur Folge, dass sich beide Kapazitäten (nämlich die des Referenzkondensators und des Kondensators aus Leitfähigkeitselektrode und Hand) zu einer Gesamtkapazität oder Ersatzkapazität addieren, welche der Summe der Einzelkapazitäten nach der Vorschrift

$$(2) \quad C \sum_{1} C_i$$

mit $i = 1, 2, 3, ...$ entspricht.

Es versteht sich, dass der Referenzkondensator als Präzisionspasoivelement ausgeführt sein muss, um bauteilbedingte Kapazitätsschwankungen ausschalten zu können. Grundsätzlich ist es natürlich auch möglich, dass die Auswerteeinheit beispielsweise temperaturbedingte Kapazitätsschwankungen des Referenzkondensators kompensiert, so dass innerhalb der Auswerteeinheit eine mehr oder minder fixe Referenzzeitspanne (entsprechend der Aufladezeit des Referenzkondensators) zur Verfügung steht.

Das heißt, die jeweils ermittelte Aufladezeit für den Referenzkondensator führt zu einer Referenzzeitspanne, die sich bei gleichbleibenden Verhältnissen von Zyklus zu Zyklus nicht ändert. Gleiches gilt fraglos, wenn man an Stelle der Aufladezeit die Entladezeit auswertet.

Dabei empfiehlt es sich, die Aufladezeit zur Ermittlung der Referenzzeitspanne über mehrere Zyklen (Aufladung und Entladung) zu mitteln und mit einer entsprechenden Fehlertoleranz auszurüsten. Diese Fehlertoleranz stellt sicher, dass nicht konstruktionsbedingte Schwankungen der Kapazität des Sensors als Annäherungen fehlinterpretiert werden. - Es versteht sich, dass naturgemäß nicht nur die Aufladezeit des Sensors zur Bildung der Referenzzeitspanne herangezogen werden kann. Sondern dies mag ebenso ergänzend oder alternativ für seine Entladezeit gelten.

Die Aufladezeit des Referenzkondensators wird als Zeitraum bis zum Erreichen eines bestimmten Schwellwertes der Ladung bzw. der Spannung des Referenzkondensators ermittelt. Das heißt, der Referenzkondensator wird beim Aufladen nicht vollständig, sondern vielmehr (nur) bis zu dem bestimmten Schwellwert aufgeladen. Gleiches gilt für den Entladevorgang. Entsprechende Vorgaben sind auch bei der Leitfähigkeitselektrode und dem Parallelkondensator zu berücksichtigen, so dass die Begriffe "Aufladen" und "Entladen" im Rahmen der Erfindung so zu verstehen sind, dass hiermit zeitlich begrenzte Lade-/Entladevorgänge gemeint sind, die meistens weder zum vollständigen Aufladen noch zum vollständigen Entladen führen. Grundsätzlich sind aber natürlich solche Vorgänge ebenfalls umfasst.

Die jeweils am Referenzkondensator (inklusive ggf. parallelem Kondensator aus Leitfähigkeitselektrode und Hand) ermittelten Aufladezeiten bzw. Aufladezeitspannen werden von Zyklus zu Zyklus einander gegenübergestellt und mit der zuvor ermittelten Referenzzeitspanne verglichen. Überschreitet die Differenz zwischen diesen beiden Zeitspannen einen vorgegebenen Differenzwert, so wird dies als Annäherung bzw. Berührung der Leitfähigkeitselektrode durch die Person interpretiert. Selbstverständlich muss dieser Differenzwert außerhalb der zuvor angegebenen Fehlergrenze bei der Ermittlung der Referenzzeitspanne durch die stattgefundene Mittelung liegen. In der Regel beträgt der vorgenannte Differenzwert ein Vielfaches dieser Fehlergrenze, um Fehlinterpretationen von Kapazitätsvariationen als Annäherungen zu vermeiden.

Solche Fehler können auch durch Umwelteinflüsse hervorgerufen werden, die Kapazitätsänderungen bedingen. So führt beispielsweise auf die Leitfähigkeitselektrode, welche zumeist in einer Handhabe eines Kraftfahrzeuges angeordnet ist, fallender Regen oder allgemein Luftfeuchtigkeit dazu, dass die Kapazität des Sensors aus der Leitfähigkeitselektrode und der Person bzw. Hand steigt. Das lässt sich im Kern darauf zurückführen, dass der sich auf der Leitfähigkeitselektrode (wenigstens zum Teil) niederschlagende Flüssigkeitsfilm als Dielektrikum wirkt und demzufolge die Kapazität C des betreffenden Kondensators im Vergleich zur Kapazität $C_0$ ohne Dielektrikum nach Maßgabe der Dielektrizitätszahl $\varepsilon_r$ steigert:

$$(3) \quad C = \varepsilon_r \cdot C_0$$

So kann die Dielektrizitätszahl $\varepsilon_r$ von Wasser Werte von ca. 70 bis 80 je nach Temperatur des Wassers annehmen, wodurch sich die Kapazitätserhöhung gemäß (3) erklärt.

Derartige, durch Umwelteinflüsse bedingte, Kapazitätsänderungen des Sensors werden im Rahmen der Erfindung erfasst. Hierbei wird die Erkenntnis genutzt, dass solche Änderungen zumeist auf großen Zeitskalen von Minuten, wenn nicht sogar Stunden stattfinden und sich selten bis in den sekundenbereich hinein auswirken. Da die hieraus resultierenden Kapazitätsänderungen eine Rekalibrierung der Referenzzeitspanne nach sich ziehen, genügt es folglich, diese Referenzzeitspanne in Zeiträumen neu festzulegen, die unterhalb von 1 sec., bevorzugt unter 200 msec., liegen.

Sofern die Rekalibrierung in diesen Zeiträumen (weniger als 1 Sec. bzw. weniger als 200 msec.) durchgeführt wird, kann sichergestellt werden, dass innerhalb des betreffenden Zeitfensters Umwelteinflüsse praktisch keine Rolle spielen. Dagegen werden Annäherungen unmittelbar erfasst und als solche registriert, weil beispielsweise eine Hand den Ansprechabstand des Sensors in wenigen msec. erreicht.

Selbstverständlich ist es auch denkbar, dass die beschriebene Rekalibrierung gleichsam aktiv unterstützt wird, indem (Außen-)Temperatur und -Feuchte gemessen werden. Wenn das Verhalten des Sensors zuvor labortechnisch in Abhängigkeit von diesen Parametern aufgenommen worden ist, lässt sich aus den ermittelten Daten auf die damit verbundenen Kapazitätsänderungen rückschließen und gleichsam aktiv - vorauseilend - eine Rekalibrierung vornehmen, ohne dass die zuvor beschriebenen Zeitfenster berücksichtigt werden müssten. Einfacher ist es jedoch, die Rekalibrierung in etwa alle 100 msec. durchzuführen, wobei dieser Zeitraum sicherstellt, dass Umwelteinflüsse innerhalb der betreffenden Zeitspanne als nicht existent bzw. konstant angesehen werden können. Denn diese wirken sich erst über Zeiträume von Sekunden, wenn nicht Minuten oder sogar Stunden aus.

Im Ergebnis wird ein Auslösesignalgeber zur Verfügung gestellt, welcher insbesondere im Zusammenhang mit einer sogenannten "keyless entry"- oder auch einer "keyless go"-Abfrage bei einem Kraftfahrzeug eingesetzt wird. Grundsätzlich sind natürlich auch andere Einsatzgebiete denkbar. So lässt sich mit dem erfindungsgemäßen Auslösesignalgeber beispielsweise auch ein Lichtschalter einschalten, eine Tür öffnen, ein Schloss entriegeln etc.. Immer stellt der vergleichsweise einfache Aufbau sicher, dass Annäherungen einer zugehörigen Person zuverlässig registriert werden, und zwar größtenteils unabhängig von Umwelteinflüssen wie Regen, wechselnden Temperaturen etc.. Das ermöglicht die in kurzen Zeitabständen immer wiederholte Rekalibrierungsroutine.

Im Folgenden wird die Erfindung anhand einer lediglich ein Ausführungsbeispiel darstellenden Zeichnung näher erläutert; es zeigen:

Fig. 1    den erfindungsgemäßen Auslösesignalgeber bei einer schlüssellosen Betätigungs- und/oder Schließeinrichtung an einem Kraftfahrzeug schematisch,

Fig. 2    den Auslösesignalgeber beim Aufladevorgang seiner Leitfähigkeitselektrode,

Fig. 3    den Gegenstand nach Fig. 2 beim Entladen der Leitfähigkeitselektrode und gleichzeitigen Aufladen des Referenzkondensators,

Fig. 4    die Spannung bzw. Ladung am Referenzkondensator gegenüber der Zeit, einmal im ursprünglichen Zustand (durchgezogen) und einmal bei Annäherung einer Hand (strichpunktiert),

Fig. 5    den Gegenstand nach Fig. 2 schematisch bei Änderung der Umwelteinflüsse (Regen),

Fig. 6    den Prozess der Rekalibrierung am Beispiel der Spannung und Ladung am Referenzkondensator gegenüber der Zeit,

Fig. 7    die Ergebnisse nach der Fig. 4, die Rekalibrierung gemäß Fig. 6 und schließlich den Aufladevorgang bei sich annähernder Hand, wobei die ursprüngliche Zeit zum Aufladen des Referenzkondensators durchgezogen dargestellt ist, der rekalibrierte Zeitverlauf gestrichelt und schließlich der rekalibrierte Zeitverlauf bei Annäherung der Hand strichpunktiert,

Fig. 8    eine abgewandelte Ausgestaltung des Auslösesignalgebers entsprechend den Fig. 2 und 3 und

Fig. 9    den Gegenstand nach Fig. 8, reduziert auf seine wesentlichen Bestandteile.

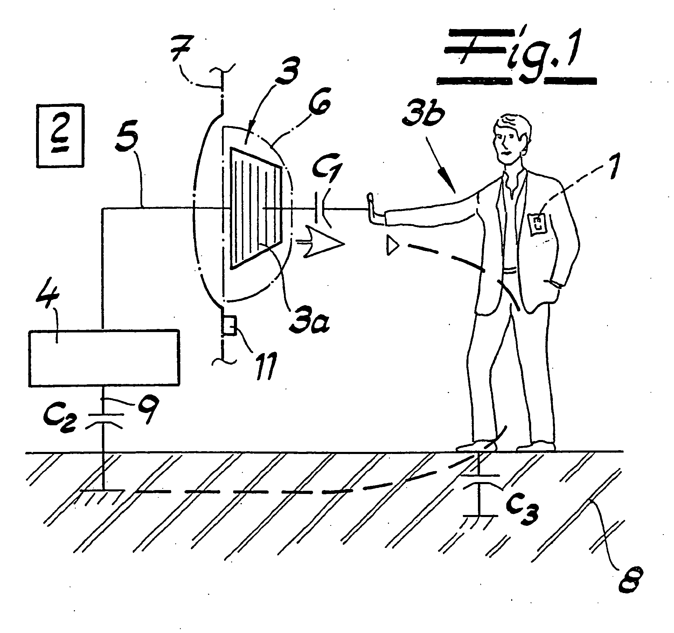

In der Fig. 1 ist eine schlüssellose Betätigungs- und/oder Schließeinrichtung in ihrem grundsätzlichen Aufbau dargestellt. Man erkennt einen zutrittswilligen Bediener bzw. eine Person 3b, welche(r) beispielsweise in einer Tasche einen bedienerspezifischen Datenträger 1 trägt. Dieser bedienerspezifische Datenträger 1 wird von einer kraftfahrzeugseitigen Steuereinheit 2 auf die Zutrittsberechtigung der betreffenden Person 3b hin abgefragt. Zu diesem Zweck läuft zumeist ein bidirektionaler Datenaustausch bzw. Dialog auf elektromagnetischem Weg (das heißt drahtlos) zwischen dem bedienerspezifischen Datenträger 1 und der kraftfahrzeugseitigen Steuereinheit 2 ab. Das ist allgemein bekannt (vgl. nur beispielhaft die EP 0 218 251 B1) und nicht Gegenstand der vorliegenden Erfindung.

Um den vorerwähnten Datenaustausch zu initiieren, ist ein Auslösesignalgeber vorgesehen, welcher im Wesentlichen einen kapazitiv arbeitenden Sensor 3 aufweist. Dieser kapazitiv arbeitende Sensor 3 verfügt über zwei Elektroden, nämlich eine Sensorelektrode bzw. Leitfähigkeitselektrode 3a einerseits und eine Hand oder ein anderes sich der Leitfähigkeitselektrode 3a näherndes Teil 3b des menschlichen Körpers bzw. der Person 3b andererseits. Bei diesem Teil 3b handelt es sich im Rahmen des Ausführungsbeispiels um die ausgestreckte Hand 3b des betreffenden Bedieners.

Die Leitfähigkeitselektrode 3a und die Hand 3b formen zusammengenommen einen Kondensator $C_1$ innerhalb des kapazitiv arbeitenden Sensors 3. Dabei führt das Annähern der Hand 3b und damit der zugehörigen Elektrode 3b in Richtung auf die Leitfähigkeitselektrode 3a zu Kapazitätsänderungen des Sensors 3, welche an eine Auswerteeinheit 4 weitergeleitet werden bzw. dort eine Auswertung erfahren. Die Auswerteeinheit 4 steht über eine Zuleitung 5 mit der Leitfähigkeitselektrode 3a in Verbindung, die ihrerseits in einen Handgriff bzw. eine Handhabe 6 eingebettet ist. Mit Hilfe dieses Handgriffes bzw. der Handhabe 6 lässt sich ein zugehöriges Kraftfahrzeug 7 öffnen, von welchem nur ein Teil einer Kraftfahrzeugtür 7 dargestellt ist. Zuvor muss jedoch ein die Kraftfahrzeugtür 7 verriegelndes Schloss entriegelt werden, was im Anschluss an die positive Datenabfrage zwischen bedienerspezifischem Datenträger 1 und kraftfahrzeugseitiger Steuereinheit 2 erfolgt.

Die durch Annäherung der Hand 3b verursachten Kapazitätsänderungen des Sensors 3 bzw. des Kondensators 3a, 3b bewegen sich zumeist im pF-Bereich, wobei sich ein Ansprechabstand von ca. 30 mm zwischen der Leitfähigkeitselektrode 3a und der Hand 3b als vorteilhaft erwiesen hat.

Die vorerwähnten Kapazitäten im pF-Bereich werden von der Auswerteeinheit 4 gemessen, die als elektronischer (Mikroprozessor-)Schaltkreis ausgeführt ist und im Rahmen des Ausführungsbeispiels kapazitiv an das Massepotential bzw. Erdpotential 8 gekoppelt ist. Hierzu dient eine Verbindungsleitung 9. Auch die Bedienperson ist mit dem Masse- bzw. Erdpotential 8 kapazitiv gekoppelt, was durch jeweils angedeutete Kondensatoren $C_2$, $C_3$ im Vergleich zum Kondensator $C_1$, gebildet durch die Elektroden 3a, 3b, angedeutet ist.

Auf diese Weise entsteht ein geschlossener elektrischer Stromkreis, so dass Kapazitätsänderungen des Kondensators $C_1$ problemlos mit Hilfe der Auswerteeinheit 4 erfasst werden können. Hierzu dienen periodische Lade-/Entladevorgänge des betreffenden Kondensators 3a, 3b bzw. der Leitfähigkeitselektrode 3a, welche von der Auswerteeinheit 4 initiiert, überwacht und ausgewertet werden, wie nachfolgend im Detail erläutert wird.

Die Elektrode 3a bzw. Leitfähigkeitselektrode 3a mag als Gitter- oder Flächenelektrode ausgeführt sein und bedienerseitig ein aufgelegtes Dielektrikum zur Isolierung aufweisen. Zusätzlich sind Abschirmungen denkbar, die gewährleisten, dass die auf der Leitfähigkeitselektrode 3a befindlichen Ladungen ein vom Kraftfahrzeug bzw. der Kraftfahrzeugtür 7 weg gerichtetes Feld formen. - Es sollte betont werden, dass der beschriebene Auslösesignalgeber nur beispielhaft zur Einleitung des zuvor erläuterten Frage-/Antwort-Dialogs im Rahmen der Zugangsberechtigungsprüfung bei einem Kraftfahrzeug eingesetzt wird. Genauso gut könnte der Auslösesignalgeber auch einfach zur Betätigung einer Lichtquelle, zur Öffnung einer Tür, Entriegelung eines Schlosses etc. Verwendung finden.

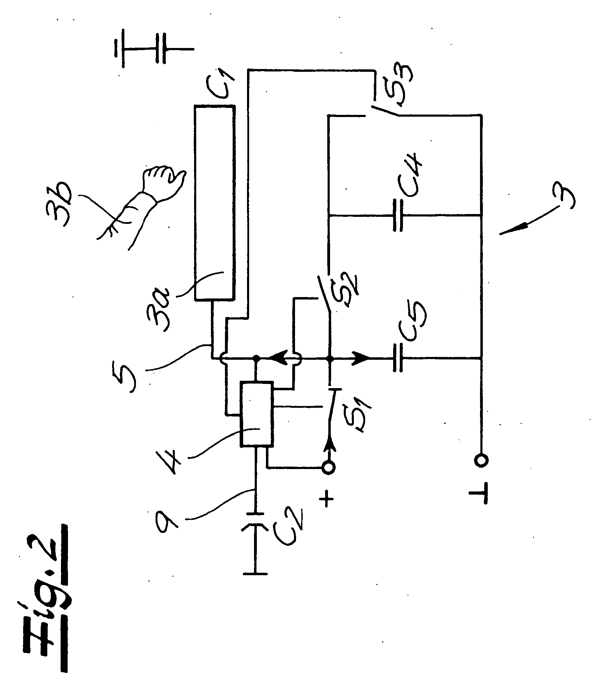

Erfindungsgemäß werden die mit Hilfe der Annäherung der Hand 3b an die Leitfähigkeitselektrode 3a verbundenen Kapazitätsänderungen als Variationen der Aufladezeit und/oder der Entladezeit des Sensors 3 ermittelt. Zu diesem Zweck verfügt der Sensor 3 - neben dem aus der Leitfähigkeitselektrode 3a und der Hand 3b gebildeten Kondensator $C_1$ - noch über einen Referenzkondensator $C_4$ (vgl. Fig. 2, 8 und 9). Zu dem Kondensator $C_1$ tritt ferner ein zumeist externer Parallelkondensator $C_5$ hinzu, wobei sich die Gesamtkapazität wegen der Gleichung (2) zu $C_{ges} = C_1 + C_5$ bemisst.

Der (externe) Parallelkondensator $C_5$ wird turnusmäßig geladen und entladen. Hierfür sorgt die Auswerteeinheit 4 in Verbindung mit einer angedeuteten Stromquelle, wobei die Auswerteeinheit 4 im Rahmen des in Fig. 2 dargestellten Ladevorganges einen Schalter $S_1$ über eine Steuerleitung schließt, bei dem es sich um einen elektronischen Schalter handelt. Neben diesem Schalter $S_1$ sind zwei weitere Schalter $S_2$ und $S_3$ vorgesehen, die bei dem beschriebenen Ladevorgang gemäß Fig. 2 geöffnet sind und ebenfalls über Steuerleitungen von der Auswerteeinheit 4 angesprochen werden.

Dadurch fließt der Ladestrom primär zum Parallelkondensator $C_5$ und von dort aus wieder zurück zur Masse bzw. zum Erdpotential 8. Bei diesem Vorgang wird der Referenzkondensator $C_4$ nicht geladen, behält also seine ggf. auf ihm befindliche Ladung Q. Da im Normalfall der Kondensator $C_1$ mit einer Kapazität von nahezu 0 ausgerüstet ist, fließt der Ladestrom - wie ausgeführt - hauptsächlich zum Parallelkondensator $C_5$. Nähert sich jedoch die Hand 3b der Leitfähigkeitselektrode 3a, so nimmt der Kondensator $C_1$ nennenswerte Werte an bzw. ändert sich seine Kapazität von 0 auf Werte im pF-Bereich. Dann fließt auch ein (geringfügiger) Ladestrom einerseits zu der Leitfähigkeitselektrode 3a und andererseits über den Parallelkondensator $C_5$ wieder zurück zur Masse bzw. zum Erdpotential 8.

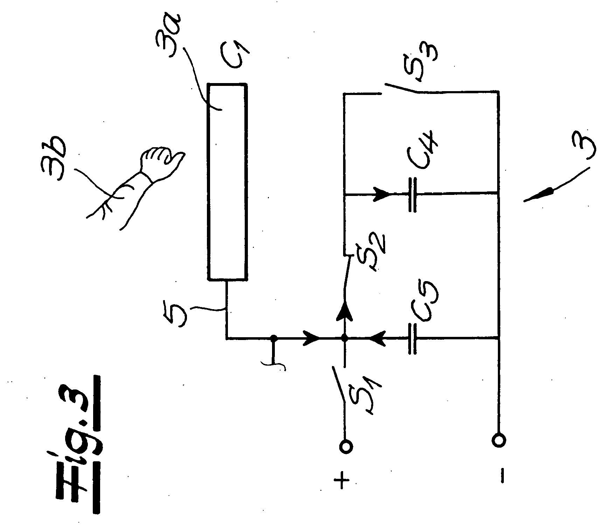

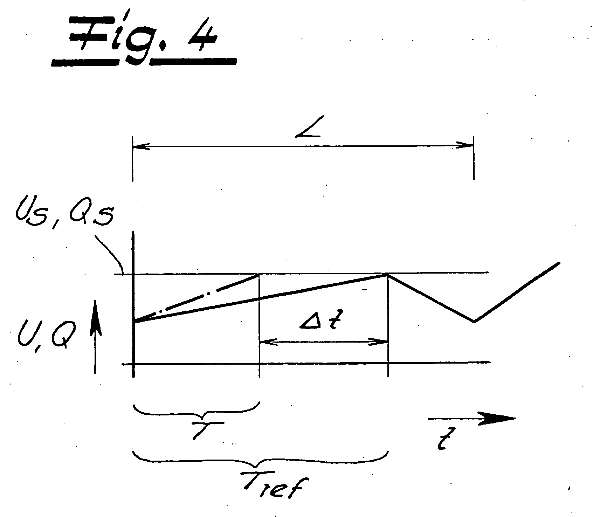

Im Anschluss an diesen Ladevorgang des Parallelkondensators $C_5$ (bzw. zusätzlich des Kondensators $C_1$) wird der Schalter $S_1$ geöffnet und der den Schaltkreis zwischen Parallelkondensator $C_5$ und dem Referenzkondensator $C_4$ verbindende Schalter $S_2$ geschlossen (vgl. Fig. 3). Der Schalter $S_3$ bleibt geöffnet. Das hat zur Folge, dass die Ladung des Parallelkondensators $C_5$ (und gegebenenfalls des Kondensators $C_1$) nunmehr auf den Referenzkondensator $C_4$ transferiert wird. Die beiden Kondensatoren $C_1$ und $C_5$ entladen sich also zugunsten einer Aufladung des Referenzkondensators $C_4$. Damit einhergehend steigen Spannung U und Ladung Q am Referenzkondensator $C_4$ entsprechend der durchgezogenen Linie nach Fig. 4. Tatsächlich folgt dieser Ladevorgang einer Exponentialkurve, weshalb die lineare Darstellung in den Fig. 4, 6 und 7 in Wirklichkeit nicht die Spannung und die Ladung am Referenzkondensator $C_4$ repräsentiert, sondern vielmehr den natürlichen Logarithmus dieser Werte.

Man erkennt, dass der Ladevorgang bei einem bestimmten Niveau der Spannung bzw. Ladung U,Q beginnt und nach Überschreiten eines Schwellwertes $U_S$, $Q_S$ endet. Dieser Schwellwert $U_S$, $Q_S$ der Spannung U am Referenzkondensator $C_4$ bzw. Ladung Q am Referenzkondensator $C_4$ kann mit Hilfe der Auswerteeinheit 4 vorgegeben werden. Sobald die betreffende Schwellspannung $U_S$ (oder die Schwellladung $Q_S$) erreicht worden ist, wird die zugehörige Aufladezeit T mittels der Auswerteeinheit 4 erfasst und wird anschließend der Schalter $S_2$ geöffnet und der Schalter $S_3$ geschlossen, so dass der dadurch bewirkte Kurzschluss den Referenzkondensator $C_4$ entlädt. Das geschieht jedoch nicht vollständig, sondern nur so lange, bis der Referenzkondensator $C_4$

erneut geladen wird, wie die Fig. 4 andeutet. Daraus lässt sich ein Lade-/Entladezyklus mit einer Dauer L ableiten.

Sofern sich keine Hand 3b der Leitfähigkeitselektrode 3a nähert und demzufolge die Kapazität $C_1$ konstant in etwa 0 ist, sind die jeweiligen Aufladezeiten T im Wesentlichen gleich bemessen und lassen sich mitteln, so dass eine Referenzzeitspanne $T_{ref}$ für die Auswertung von Annäherungen zur Verfügung steht. Der Referenzkondensator $C_4$ wird also turnusmäßig entladen, und zwar im Wesentlichen im Wechsel mit Aufladevorgängen des Parallelkondensators $C_5$. Denn der Parallelkondensator $C_5$ wird wechselweise, ebenfalls aufgeladen und entladen und gibt seine Ladung beim Entladen an den Referenzkondensator $C_4$ ab.

Der Referenzkondensator $C_4$ ist während des Ladevorganges von $C_5$ (und gegebenenfalls $C_1$) von dem Parallelkondensator $C_5$ abgekoppelt, weil dann der Schalter $S_2$ geöffnet ist. Bei diesem Schalter $S_2$ handelt es sich ebenso wie bei den Schaltern $S_1$ und $S_3$ jeweils um einen elektronischen Transistorschalter, welcher zusammen mit der Auswerteeinheit 4 und den Kondensatoren $C_4$ und $C_5$ sowie der Leitfähigkeitselektrode 3a eine kompakte elektronische Baueinheit bildet, die zusammengenommen sogar als ein Schaltkreis zur Verfügung gestellt werden kann.

Nähert sich nun jedoch die Hand 3b der Leitfähigkeitselektrode 3a, so steigt wegen der Beziehung (1) die Kapazität $C_1$ und auch die Gesamtkapazität $C_1 + C_5$ an. Das hat zur Folge, dass auch die auf beiden Kondensatoren $C_1$ und $C_5$ gespeicherte Ladung größer wird. Diese vergrößerte Ladung auf den Kondensatoren $C_1$ und $C_5$ steht dann natürlich auch beim Ladevorgang für den Referenzkondensator $C_4$ im Rahmen der Fig. 3 zur Verfügung. Das führt dazu, dass der Ladevorgang des Referenzkondensators $C_4$ insgesamt schneller vonstatten geht, weil der fließende Strom wegen

$$(4)\ I = \frac{dQ}{dt}$$

steigt. Gleichzeitig findet der Ladungsaufbau am Referenzkondensator $C_4$ und auch der Spannungsaufbau im Vergleich zur bisherigen Situation (durchgezogene Linie in Fig. 4) schneller statt, was der strichpunktierte Verlauf ausdrückt. Damit einhergehend verringert sich die Aufladezeit T bis zum Erreichen der Schwellspannung $U_S$ und folglich auch die Zykluszeit L, und zwar um den Betrag $\Delta t$. Es gilt also

$$(5)\ \Delta t = T_{ref} - T.$$

Sobald der ermittelte Differenzwert zwischen den jeweiligen Aufladezeitspannen $T_{ref}$ und T, das heißt die Zeitspanne $\Delta t$, einen vorgegebenen Differenzwert

überschreitet, lässt sich dies als Annäherung interpretieren. Im Rahmen der Erfindung wird eine solche Annäherung erst dann gemeldet, wenn $\Delta t$ ein Vielfaches der zuvor bereits angesprochenen Fehlervariation bei der Bestimmung der gemittelten Referenzzeitspanne $T_{ref}$ beträgt.

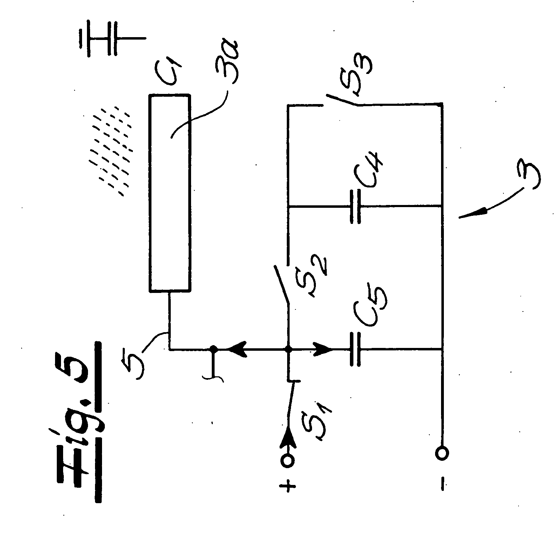

Durch Umwelteinflüsse können sich Kapazitätsänderungen des Sensors 3 ergeben, die mit Bezug zu den Fig. 5, 6 und 7 näher erläutert werden, und zwar am Beispiel von Regen oder Nebel als Umwelteinfluss. Derartige Änderungen der Messbedingungen rufen Kapazitätsänderungen des Sensors 3 bzw. des zugehörigen Kondensators 3a, 3b bzw. $C_1$ nach Maßgabe der Vorschrift (3) hervor. Tatsächlich führt nämlich ein Feuchtigkeitsfilm zumeist zu einer Kapazitätserhöhung von $C_1$ (vgl. Fig. 5).

Diesen durch Umwelteinflüsse bedingten Kapazitätsänderungen wird durch eine Rekalibrierung der Referenzzeitspanne $T_{ref}$ begegnet. Die Rekalibrierung wird in bestimmten vorgegebenen Zeitabständen vorgenommen, die im Bereich von ca. 100 bis 200 msec., auf jeden Fall unter einer Sekunde, betragen.

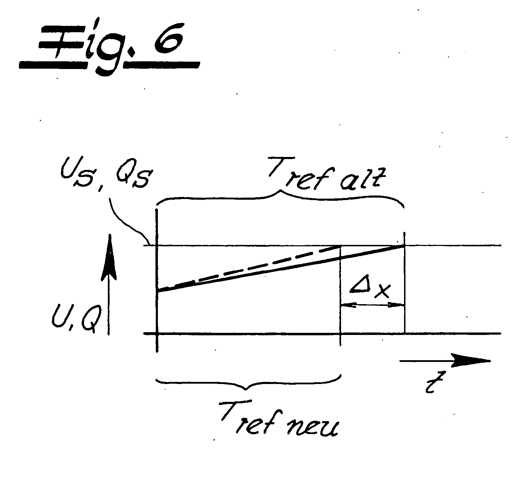

Die Rekalibrierung führt dazu, dass die erhöhte Kapazität $C_1$ eine verringerte Aufladezeit $T_{ref\ neu}$ nach sich zieht, wie dies in Fig. 6 im Vergleich zur ursprünglichen Referenzzeitspanne $T_{ref\ alt}$ dargestellt ist. Die Differenz zwischen $T_{ref\ alt}$ und $T_{ref\ neu}$ bemisst sich zu $\Delta x$. Das hat zur Folge, dass die Empfindlichkeit des Sensors gleichbleibend ist und insbesondere Umwelteinflüssen (Regen, Temperatur) Rechnung trägt.

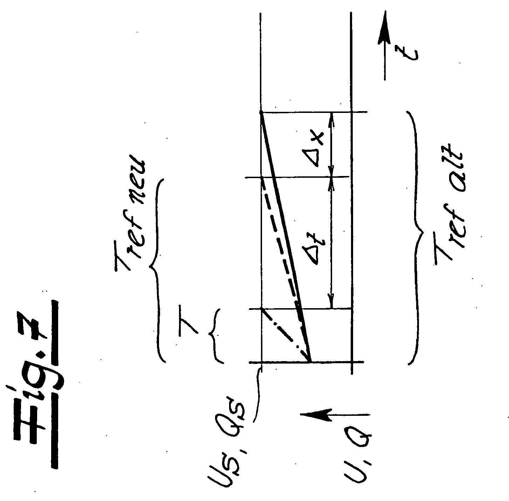

Das kommt in der Fig. 7 zum Ausdruck, welche den Ladevorgang unter Berücksichtigung der ursprünglichen Ladezeit $T_{ref\ alt}$ (durchgezogen) mit der neuen Ladezeit $T_{ref\ neu}$ (gestrichelt) vergleicht und diese neue Aufladezeit $T_{ref\ neu}$ nach der Rakalibrierung einer Aufladezeit T bei Annäherung einer Person 3b gegenüberstellt (strichpunktiert). Man erkennt, dass sich die Empfindlichkeit des Sensors 3, welche am Betrag $\Delta t$ festgemacht werden kann, nicht ändert, weil durch die Rekalibrierung lediglich eine Verschiebung der Referenzzeitspanne $T_{ref}$ um den Betrag $\Delta x$ vorgenommen worden ist.

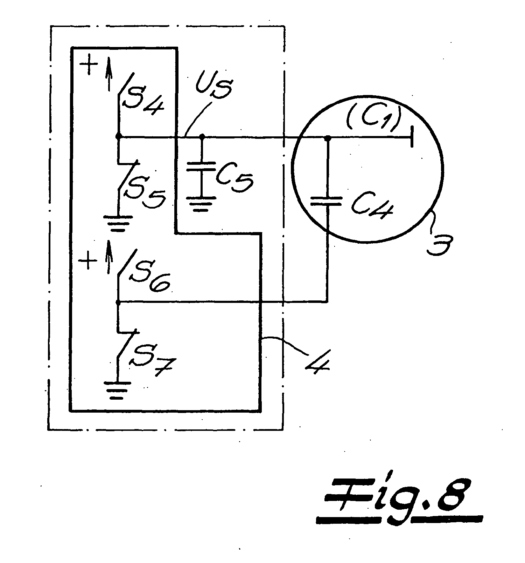

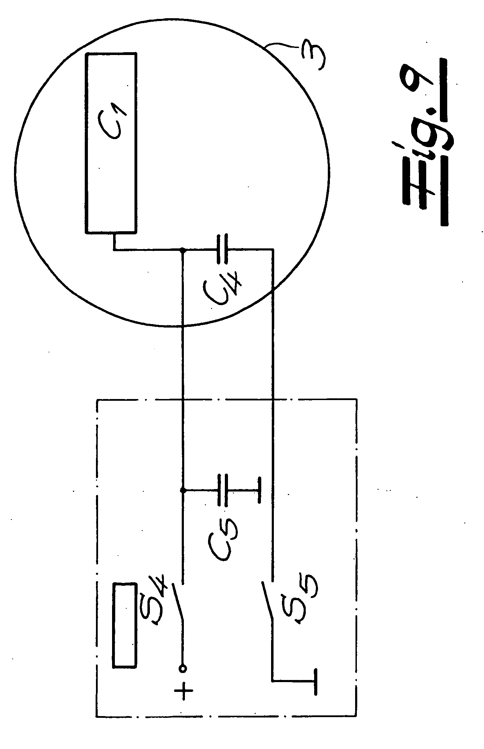

Die Auswerteeinheit 4 und der Parallelkondensator $C_5$ bilden in der Regel eine kompakte Elektronikeinheit. Tatsächlich handelt es sich hierbei im Rahmen des Ausführungsbeispiels zusammengenommen um einen Mikrocomputer, in welchen der Parallelkondensator $C_5$ integriert ist (vgl. die strichpunktierte Darstellung in den Fig. 8 und 9). Selbstverständlich können in diesen Mikrocomputer in gleicher Weise auch die Schalter $S_1$, $S_2$ und $S_3$ mit den zugehörigen Steuerleitungen eingefügt sein, so dass als externe Bauteile lediglich die Leitfähigkeitselektrode 3a und der Referenzkondensator $C_4$ verbleiben. Das führt zu einer kostengünstigen Bauweise, wobei vom Erfindungsgedanken natürlich auch Variationen dergestalt umfasst werden, dass ebenso die beiden vorgenannten Bauteile 3a, $C_4$ insgesamt in einen elektronischen Schaltkreis integriert werden.

Auch bei der Variante nach den Fig. 8 und 9

sind dortige Schalter $S_4$ bis $S_7$ mit zugehörigen Steuerleitungen in Verbindung mit dem Parallelkondensator $C_5$ in eine kompakte Elektronikeinheit integriert. Das ist durch die strichpunktierte Umrahmung angedeutet, welche die Auswerteeinheit 4 und den Parallelkondensator $C_5$ zusammenfasst. Demgegenüber verbleiben lediglich der Referenzkondensator $C_4$ und der Kondensator $C_1$.

Die Funktionsweise dieser Variante ist wie folgt. Im Ausgangszustand addiert sich die Gesamtkapazität der jeweils parallel geschalteten Kondensatoren $C_1$, $C_4$ und $C_5$ zu Null. Zum Aufladen des Parallelkondensators $C_5$ wird der Schalter $S_4$ geschlossen, während die übrigen Schalter $S_5$ bis $S_7$ geöffnet sind. Im Anschluss daran wird $C_5$ mit einer Kapazität von ca. 10 bis 20 pF, insbesondere 15 pF, aufgeladen. Darauf folgend werden die Schalter $S_4$ und $S_7$ geschlossen bzw. auf Masse geschaltet, während die Schalter $S_5$ und $S_6$ geöffnet bleiben. Dadurch wird die auf dem Parallelkondensator $C_5$ befindliche Ladung auf den Referenzkondensator $C_4$ übertragen. Gleichzeitig entlädt sich der Parallelkondensator $C_5$.

Das zyklische Aufladen des Parallelkondensators $C_5$ und dessen Entladen durch Ladungsübertragung auf den Referenzkondensator $C_4$ wird so lange wiederholt, bis der Referenzkondensator $C_4$ aufgeladen ist. Dieser verfügt zumeist über eine erheblich höhere Kapazität als der Parallelkondensator $C_5$. Es haben sich Kapazitäten für den Referenzkondensator $C_4$ von in etwa 50 $\mu$F als günstig erwiesen. Der Ladezustand $U_{gem}$ des Referenzkondensators $C_4$ lässt sich im Vergleich zu der vorgegebenen Schwellspannung $U_S$ messen, und zwar beispielsweise an der in Fig. 8 angedeuteten Stelle. Aus der gemessenen Spannung $U_{gem}$ und der Schwellspannung $U_S$ können zwei grundsätzliche Ausgangswerte abgeleitet werden. Falls

$$(6) \quad U_{gem} \geq U_S,$$

wird beispielhaft die binäre Information "1" von der Auswerteeinheit 4 erzeugt und zur weiteren Verarbeitung ausgegeben. Die "1" repräsentiert den aufgeladenen Zustand des Referenzkondensators $C_4$. Für den Fall, dass gilt

$$(7) \quad U_{gem} < U_S,$$

ist der Referenzkondensator $C_4$ (noch) nicht geladen, so dass die zuvor beschriebenen Ladevorgänge weitergeführt werden müssen. Die binäre Information ist "0".

Nun können diese wiederholten Ladevorgänge von der Auswerteeinheit 4 jeweils erfasst und gezählt werden. Sobald sich die binäre Information "1" einstellt, wird der Zählvorgang abgebrochen und die Anzahl der Zyklen $N_{Z1}$ festgehalten. Im Anschluss daran wird der Referenzkondensator $C_4$ entladen, in dem die Schalter $S_4$, $S_5$ und $S_6$ geöffnet werden, während der geschlossene Schalter $S_7$ für den gewünschten Ladungstransport sorgt.

Sobald der aus der Hand 3b und der Leitfähigkeitselektrode 3a gebildete Kondensator 3a, 3b bzw. $C_1$ nennenswerte Kapazitäten erreicht (weil sich ein Bediener genähert hat) ändert sich die Anzahl der erforderlichen Zyklen, bis nun der Referenzkondensator $C_4$ inklusive parallel geschaltetem Kondensator $C_1$ in der Summe aufgeladen ist (vgl. die Beziehung (2)). Denn die Parallelschaltung des Referenzkondensators $C_4$ und des Kondensators $C_1$ führt zu einer addierten Kapazität. Diese erfordert nun eine erhöhte Anzahl von Zyklen $N_{Z2}$, bis der jeweilige Ladungstransfer des Parallelkondensators $C_5$ die vorgenannte Gesamtkapazität aufgeladen hat, d. h. bis die Schwellspannung $U_S$ erreicht worden ist.

Daraus resultiert die neue Zahl an gemessenen Zyklen $N_{Z2}$. Sobald die Differenz

$$(8) \quad \Delta N_Z = N_{Z1} - N_{Z2}$$

einen bestimmten Wert überschritten hat, wird dies als zweifelsfreie Annäherung einer Bedienperson interpretiert. $\Delta N_Z$ entspricht also im Wesentlichen der zuvor beschriebenen Zeitdifferenz $\Delta t$ (vgl. Fig. 4,7).

Falls sich diese Änderungen der Zyklenzahl $\Delta N_Z$ auf längeren Zeitskalen abspielen, kann auf diese Weise eine Rekalibrierung vorgenommen werden. Denn Änderungen der Umwelteinflüsse schlagen sich unmittelbar in einer abweichenden Zykluszahl $N_Z$ nieder, die als neuer Referenzwert $N_{Z1}$ für nachfolgende Auswertungen von Annäherungen zur Verfügung steht. Das heißt, hier wird ähnlich gearbeitet wie zuvor erläutert. Umwelteinflüsse führen zu einer neuen Zykluszahl $N_{z neu}$ bzw. $N_{Z1}$, die gegenüber der ursprünglichen Zykluszahl $N_{Z alt}$ um den Betrag $\Delta x$ abweicht. $N_{Z neu}$ wird nun mit $N_{Z1}$ gleichgesetzt, um $\Delta N_Z$ entsprechend der Beziehung (8) bestimmen zu können.

**Patentansprüche**

1. Kraftfahrzeug (7) mit einem Auslösesignalgeber, beispielsweise zur Einleitung eines Frage-/Antwort-Dialogs im Rahmen einer Zugangsberechtigungsprüfung, mit einem kapazitiv arbeitenden Sensor (3), und mit einer Auswerteeinheit (4), wobei der Sensor (3) Annäherungen und/oder Berührungen beispielsweise einer Person (3b) als zugehörige Kapazitätsänderungen erfasst und an die Auswerteeinheit (4) weiterleitet, **dadurch gekennzeichnet, dass** der Auslösesignalgeber einen Sensor (3) mit einem Referenzkondensator (C4) und einen Parallelkondensator (C5) aufweist, wobei der Parallelltondensator (C5) turnusmäßig geladen und entladen wird und seine Ladung beim Entladen an den Referenzkondensator (C4) abgibt, und die Kapazitätsänderungen des Sensors (3) als Variationen der Aufladen- / und Entladezyklen ($N_z$) des Parallelkondensators (C5) ermittelt werden.

2. Kraftfahrzeug mit einem Auslösesignalgeber nach Anspruch 1, **dadurch gekennzeichnet, dass** der Sensor (3) eine Leitfähigkeitselektrode (3a) aufweist, die auf Annäherung/Berührungen der Person (3b) im Sinne einer Kapazitätsänderung des aus der Leitfähigkeitselektrode (3a) und der Person (3b) gebildeten Kondensators ($C_1$) reagiert.

3. Kraftfahrzeug mit einem Auslösesignalgeber nach Anspruch 1 und 2, **dadurch gekennzeichnet, dass** die Auflade-/ und Entladezyklen des Parallelkondensators (C5) zum Aufladen des Referenzkondensators (C4) als Maß zum Erreichen eines bestimmten Schwellwertes des Referenzkondensators (C4) durch die Auswerteeinheit (4) als Referenzwert ($N_{Z1}$) erfasst werden.

4. Kraftfahrzeug mit einem Auslösesignalgeber nach einem der Ansprüche 1 bis 3, **dadurch gekennzeichnet, dass** die ermittelten Auflade-/ und Entladezyklen ($N_{Z2}$) des Parallelkondensators (C5) durch die Auswerteeinheit (4) erfasst werden, mit dem Referenzwert der Auflade-/ und Entladezyklen ($N_{Z1}$) verglichen werden und bei Überschreiten eines vorgegeben Differenzwertes ($\Delta N_z$) als Annäherung/Berührung des Sensors (3) durch die Person (3b) interpretiert werden.

5. Kraftfahrzeug mit einem Auslösesignalgeber nach einem der Ansprüche 1 bis 4, **dadurch gekennzeichnet, dass** durch Umwelteinflüsse bedingte Kapazitätsänderungen des Sensors (3) erfasst werden und eine Rekalibrierung des Referenzwertes der Auflade-/ und Entladezyklen ($N_{Z1}$) nach sich zieht.

6. Kraftfahrzeug mit einem Auslösesignalgeber nach einem der Ansprüche 1 bis 5, **dadurch gekennzeichnet, dass** die Rekalibrierung in bestimmten vorgegebenen Zeitspannen, z. B. alle 100 bis 200 msec., vorgenommen wird.

## Claims

1. Vehicle (7) comprising a activating transducer, for instance for initiating a query/answer dialogue as part of an access authorization check, with a capacitively working sensor (3), and an evaluation unit (4), in which the sensor (3) determines approaches and/or contacts of, for instance, a person (3b) as respective capacity change and passes them on to the evaluation unit (4), **characterized in that**, the activating transducer comprises a sensor (3) containing a reference capacitor (C4) and a parallel capacitor (C5), in which the parallel capacitor (C5) is charged and discharged in turn and gives off its charge during discharging to the reference capacitor (C4), and the capacity changes of the sensor (3) are determined as variations of the charging and discharging cycles ($N_z$) of the parallel capacitor (C5).

2. Vehicle (7) with an activating transducer according to claim 1, **characterized in that** the sensor (3) contains a conductivity electrode (3a), reacting to the approach/contact of the person (3b) in the sense of a capacity change of the capacitor ($C_1$) formed from the conductivity electrode (3a) and the person (3b).

3. Vehicle (7) with an activating transducer according to claim 1 and 2, **characterized in that** the charging and discharging cycles of the parallel capacitor (C5) for charging the reference capacitor (C4) are determined by the evaluation unit (4) as reference value ($N_{Z1}$) as a measure for reaching a certain threshold value of the reference capacitor (C4).

4. Vehicle (7) with an activating transducer according to one of the claims 1 to 3, **characterized in that** the determined charging and discharging cycles ($N_{Z2}$) of the parallel capacitor (C5) are determined by the evaluation unit (4), compared with the reference value of the charging and discharging values ($N_{Z1}$) and are interpreted as approaches/contacts of the sensors (3) by the person (3b) if a stipulated differential value ($\Delta N_z$) is exceeded.

5. Vehicle (7) with an activating transducer according to one of the claims 1 to 4, **characterized in that** capacity changes of the sensor (3) caused by environmental conditions are determined and trigger a recalibration of the reference value of the charging and discharging cycles ($N_{Z1}$).

6. Vehicle (7) with an activating transducer according to one of the claims 1 to 5, **characterized in that** the recalibration is carried out in certain stipulated intervals, e.g. every 100 to 200 msec.

## Revendications

1. Véhicule à moteur (7) avec un émetteur de signal de déclenchement, p.ex pour entamer un dialogue question/réponse dans le cadre d'un test d'autorisation d'accès avec détecteur (3) capacitif et une unité d'analyse (4), le détecteur (3) saisissant les rapprochements et/ou les contacts par exemple d'une personne (3b) comme modification inhérente de capacité et transmettant à l'unité d'analyse (4) **caractérisé en ce que** l'émetteur de signal de déclenchement présente un détecteur (3) avec un condensateur de référence (C4) et un condensateur parallèle (C5), le condensateur parallèle (C5) se chargeant et de déchargeant alternativement et sa charge lors de la décharge étant fournie au condensateur de référence (C4) et la modification de capacité du détecteur (3) étant déterminée comme variations des cycles de charge et de décharge ($N_z$) du condensateur parallèle (C5).

2. Véhicule à moteur (7) avec un émetteur de signal de déclenchement selon la revendication 1 **caractérisé en ce que** le détecteur (3) présente une électrode de conductibilité (3a) réagissant au rapprochement/au contact de la personne (3b) dans le sens d'une modification de capacité du condensateur (C1) formé de l'électrode de conductibilité (3a) et de la personne (3b).

3. Véhicule à moteur (7) avec un émetteur de signal de déclenchement selon les revendications 1 et 2 **caractérisé en ce que** les cycles de charge et de décharge du condensateur parallèle (C5) pour recharger le condensateur de référence (C4) sont saisis comme mesure pour atteindre une certaine valeur seuil du condensateur de référence (C4) par l'unité d'analyse (4) comme valeur de référence ($N_{Z1}$).

4. Véhicule à moteur (7) avec un émetteur de signal de déclenchement selon l'une des revendications 1 à 5, **caractérisé en ce que** les cycles de charge et de décharge déterminés ($N_{Z2}$) du condensateur parallèle (C5) sont saisis par l'unité d'analyse (4), comparés avec la valeur référence des cycles de charge et de décharge ($N_{Z1}$) et en cas de dépassement d'une valeur différentielle ($\Delta N_z$) donnée interprétés comme rapprochement/contact du détecteur (3) par la personne (3b).

5. Véhicule à moteur (7) avec un émetteur de signal de déclenchement selon l'une des revendications 1 à 4, **caractérisé en ce que** les modifications de capacité du détecteur (3) dues aux influences de l'environnement sont saisies générant un recalibrage de la valeur référence des cycles de charge et de décharge ($N_{Z1}$).

6. Véhicule à moteur (7) avec un émetteur de signal de déclenchement selon l'une des revendications 1 à 5, **caractérisé en ce que** le recalibrage est réalisé à certains intervalles donnés p.ex. toutes les 100 à 200 msec.

Fig.1

Fig.2

Fig.3

# Fig. 4

Fig. 5

Fig. 6

Fig.7

Fig.8

Fig. 9